# EUROPEAN PATENT APPLICATION

(11) **EP 1 758 179 A1**
(43) Date of publication of application: **28.02.2007**
(21) Application number: 05741530.9
(22) Date of filing: 18.05.2005
(51) Int. Cl.: H01L 33/00, F21S 8/10

(54) **FIXING DEVICE AND FIXING STRUCTURE FOR LIGHT EMITTING DIODE**

(30) Priority: 26.05.2004 JP 2004156294
(71) Applicant: Advanex Inc., Tokyo 114-8581 (JP)
(72) Inventor: OOKI, Yoshinobu, ADVANEX INC., Kita-ku, Tokyo 1148581 (JP); IMAI, Tatsuyoshi, ADVANEX INC., Kita-ku, Tokyo 1148581 (JP)
(74) Representative: Poulin, Gérard
(86) International application number: PCT/JP2005/009059
(87) International publication number: WO 2005/117149

(57) **Abstract**

A fixing device for a light emitting diode having plate-shaped lead terminals, includes a device body that is to be fixed to a base part and a cut-out piece formed integrally with the device body and fixing the lead terminals to a surface of the device body, wherein the cut-out piece is formed so that a distal end of the cut-out piece faces the surface of the device body by being erected and folded back from the device body, and the light emitting diode is detachably fixed to the base part by clamping each of the lead terminals inserted between the distal end of the cut-out piece and the surface of the device body.

## Description

### TECHNICAL FIELD

The present invention relates to a fixing device and a fixing structure for a light emitting diode suitable for use in a light source such as a lamp for a vehicle.

Priority is claimed on Japanese Patent Application No. 2004-156294, filed May 26, 2004, the content of which is incorporated herein by reference.

### BACKGROUND ART

In recent years, light emitting diodes have been adopted as light sources in various fields due to their long life and low power consumption. Such light emitting diodes are generally fixed to a base part by having lead terminals extending from the diode body fixed to a fixing device in the form of lead frames that are fixed to the base part by soldering or the like. Also, plate-shaped lead terminals, which effectively radiate heat generated by a light emitting diode, are becoming increasingly common in light emitting diodes.

In the case of adopting light emitting diodes as light sources such as vehicle lamps, numerous light emitting diodes are arranged and fixed to a base part to secure a predetermined quantity of light and light-emitting area. Also, after fixing of the light emitting diodes, lighting confirmation is performed during which any defective diodes are replaced. In order to facilitate the fixing and replacement operations, there is a fixing structure (for example, refer to Patent Document 1) in which one of the lead terminals of a light emitting diode is inserted in the device body of the fixing device, and in this state, using a locking component that is separate from the device body, the other lead terminal is held. Thereby, the light emitting diode is constituted to be detachably fixed to a base part.
Patent Document 1: Japanese Unexamined Patent Application, First Publication No. 2003-331635

### DISCLOSURE OF THE INVENTION

### PROBLEMS TO BE SOLVED BY THE INVENTION

However, in the constitution described above, since the light emitting diode is fixed using a locking component that is separate from the device body, a problem arises of a rise in cost accompanying the increase in the number or parts.

Therefore, the present invention has as its object to provide a fixing device and a fixing structure for a light emitting diode that can facilitate operations to fix and replace a light emitting diode while suppressing an increase in the number of parts.

### MEANS FOR SOLVING THE PROBLEM

As a means of solving the aforementioned problem, the fixing device for a light emitting diode according to the present invention is a fixing device for a light emitting diode having plate-shaped lead terminals, includes a device body that is to be fixed to a base part; and a cut-out piece formed integrally with the device body and fixing the lead terminals to a surface of the device body, wherein the cut-out piece is formed so that a distal end of the cut-out piece faces the surface of the device body by being erected and folded back from the device body, and the light emitting diode is detachably fixed to the base part by clamping each of the lead terminals inserted between the distal end of the cut-out piece and the surface of the device body.

This constitution enables fixing of a light emitting diode to a base part by inserting the lead terminals between the surface of the device body and the cut-out piece along the surface of the device body of the fixing device that is fixed to the base part in advance. In the reverse procedure, the light emitting diode can be removed from the base part. That is, compared to the case of the lead terminals of the light emitting diode being fixed to a fixing device by soldering or the like, since each lead terminal is mechanically held by the device body and the cut-out piece, the light emitting diode is easily detachable with respect to the base part.

At this time, the edge of the distal end of each cut-out piece is made to bite into the lead terminals. Thereby, not only movement of the lead terminals in a direction vertical to the device body surface but also movement in a direction along the surface of the device body surface can be effectively restricted.

Moreover, since each cut-out piece, which clamps the lead terminals, is integrally provided with the device body, an increase in the number of parts of the fixing device can be suppressed.

Also, in the fixing device for a light emitting diode according to the present invention, based on the invention above, the device body includes an elastic piece that urges the lead terminals toward the device body in order to cause the lead terminals to make surface contact with the surface of the device body.

This constitution enables the lead terminals to make surface contact with the device body surface during fixation of the light emitting diode. For this reason, the dissipation from the lead terminals of the heat produced from the light emitting diode can be improved, and the reliability of the contact between the fixing device and the lead terminals can be improved.

Moreover, in the fixing device of the light emitting diode according to the present invention, based on the above invention, the device body includes a locking piece that engages a notch portion provided on each of the lead terminals in order to perform positioning of the lead terminals with respect to the device body.

This constitution causes the fixing piece to engage with the notch portion during fixation of the light emitting diode, so that it is possible to position the lead terminals with respect to the device body, and possible to restrict movement of the lead terminals with respect to the device body.

Moreover, a fixing structure for a light emitting diode according to the present invention is a fixing structure for a light emitting diode by using the fixing device according to any one of claims 1 through 3 to fix a light emitting diode.

It can be said to be particularly effective to adopt this structure for a vehicle lamp in which numerous light emitting diodes are exposed to various vibrations.

### ADVANTAGEOUS EFFECTS ON THE INVENTION

The fixing structure for a light emitting diode according to the present invention can reduce the work man-hours when fixing and replacing the light emitting diodes to a base part. Also, dropping out of light emitting diodes and poor contact with the fixing device can be prevented. In addition, the cost of components can be reduced, and the work man-hours required for fixing of light emitting diodes and the work man-hours required for parts management can be reduced.

Also, the fixing device for a light emitting diode according to the present invention can increase the heat dissipation and the contact reliability of a light emitting diode.

Moreover, the fixing device for a light emitting diode according to the present invention can simplify the work of fixing a light emitting diode to a base part, and can more effectively prevent dropping out of light emitting diodes and poor contact of a light emitting diode with the fixing device.

Also, even in vehicle lamps in which numerous light emitting diodes are exposed to various vibrations, the fixing structure for a light emitting diode according to the present invention can reduce the work man-hours of fixing and replacing light emitting diodes and can prevent dropping out and poor contact of light emitting diodes.

### BRIEF DESCRIPTION OF THE DRAWINGS

FIG. 1 is a perspective view of a light emitting diode (LED) and a lead frame (fixing device) in one embodiment of the present invention.
FIG. 2 is a top view of the lead frame.
FIG. 3 is a rear view of the lead frame.
FIG. 4 is a cross-sectional view along line A-A in FIG. 2.
FIG. 5 is a cross-sectional view along line B-B in FIG. 2.
FIG. 6 is a cross-sectional view along line D-D in FIG. 3.

### DESCRIPTION OF THE REFERENCE SYMBOLS

11, 12: lead frames (fixing devices)
13: frame body (device body)
14a: cut-out piece
16: elastic piece
17: elastic locking piece (locking piece)
30: LED (light emitting diode)
33, 34: lead terminals
38: notch portion

### BEST MODE FOR CARRYING OUT THE INVENTION

An embodiment of the present invention shall be described below with reference to the appended drawings.

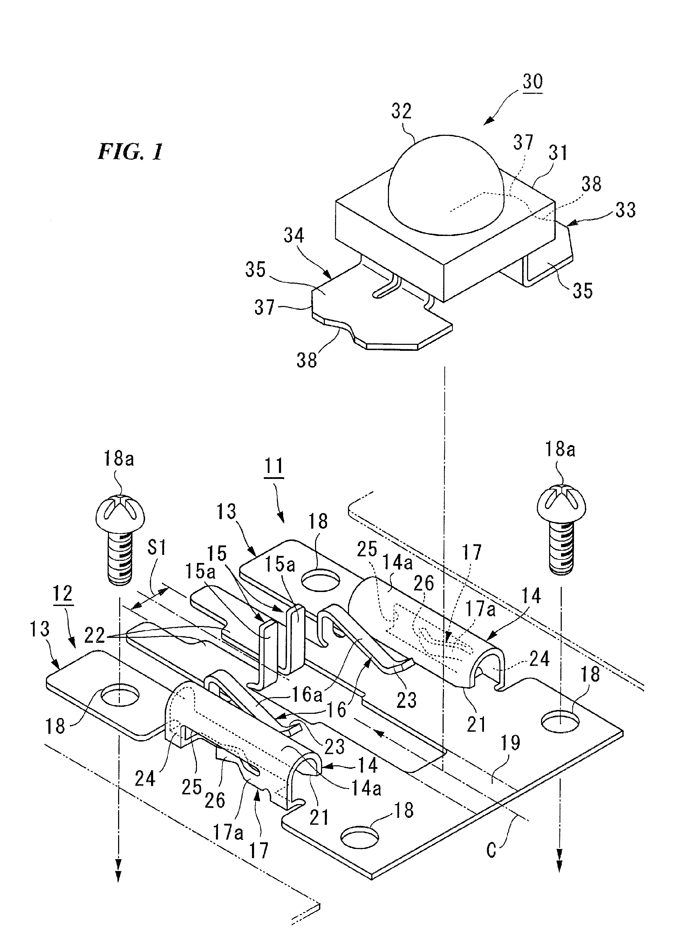

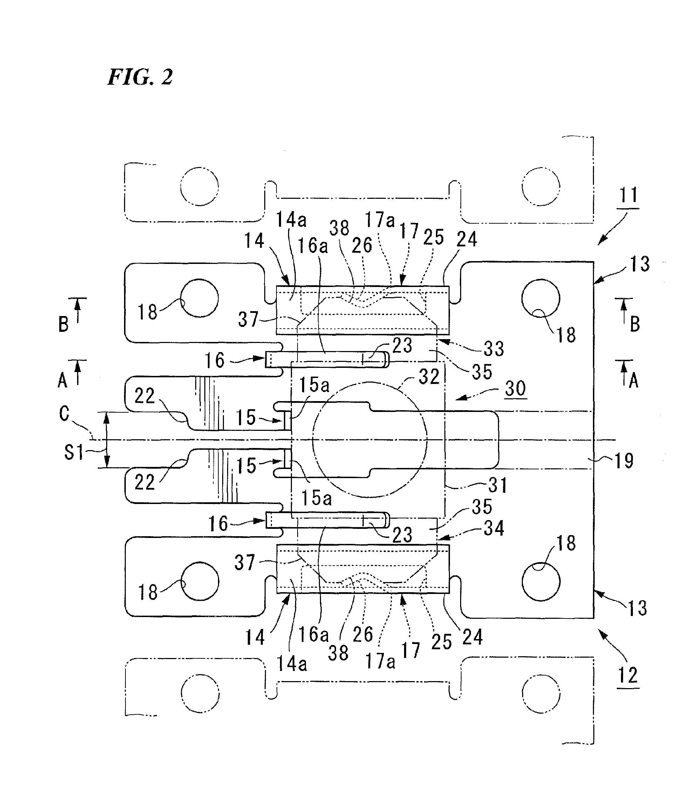

In FIGS. 1 and 2, reference numerals 11 and 12 denote anode side and cathode side lead frames (fixing devices) made of a conductive material, such as a copper plate. A light emitting diode (LED) 30 is fixed to a base part, not illustrated, made of an insulating material such as resin via these lead frames 11 and 12. This base part is a housing for a light such as a vehicle taillight, and by numerous LEDs 30 being arranged in this housing, secures a predetermined light-emitting area and quantity of light.

The LED 30 is fixed to the base part by using the lead frame 11 or 12 separately for each respective pole. In the lead frames 11 and 12, each of the parts of a plate-shaped frame body (device body) 13 that forms a mostly rectangular shape viewed from the front are cut up, to thereby form a curl portion 14, an erect wall portion 15, an elastic piece 16, and an elastic locking piece (locking piece) 17 that are described in detail below.

The lead frames 11 and 12 are disposed to be mutually parallel, with the long side portions of their respective frame bodies 13 being adjoined with a predetermined gap S1. Below, the direction intersecting the top surface (front face) of each frame body 13 is described as the vertical direction, the direction in which the frame bodies 13 adjoin is described as the lateral direction, and the direction along center line C (the center line in the longitudinal direction) between the frame bodies 13 is described as the fore-aft direction.

The lead frames 11 and 12 have a mirror-image symmetry along the center line C, with screw holes 18 formed in the front and rear end portions thereof. Screws 18a that are inserted in these screw holes 18 are fastened to the base part, and thereby each of the lead frames 11 and 12 are fastened to the base part. Here, the lead frames 11 and 12 are joined via an easily severable joining piece 19 that extends along the inside edge of the rear end portion, so that during fixing to a base part, the lead frames 11 and 12 can be managed as a single component, and after being fixed the lead frames 11 and 12 can be made independent of each other by cutting the joining piece 19.

The LED 30 in this embodiment is a widely known one in which a hemispherical lens portion 32 is integrally formed on a body 31 having a flat, square block shape in the vertical direction, with a pair of lead terminals 33 and 34 which become the anode side and the cathode side being drawn from both side portions of the undersurface of the body 31.

The lead terminals 33 and 34 are plate-shaped components that are provided approximately parallel with the edges on both sides of the undersurface of the body 31, being disposed so as to face each other with a predetermined gap. Also, the lead terminals 33 and 34, after extending downward from the undersurface of the body 31, are bent in directions turning away from each other to form a comparatively large-sized flat portion 35 that is disposed parallel to the top surface of each frame body 13. In the portions along the vertical direction of the lead terminals 33 and 34, for fabrication convenience, slits are formed in the center portion in the width direction.

The flat portion 35 of each of the lead terminals 33 and 34 is electrically connectable with the frame body 13 by the undersurface thereof making surface contact with the top surface of the frame body 13 of the corresponding lead frame 11 or 12. Also, the flat portions 35 are formed broadly while extending in opposite directions at the bottom end portions of the lead terminals 33 and 34. Thereby, the contact surface area with the frame body 13 is expanded to increase the dissipation of heat generated by the LED 30 to the lead frames 11 and 12.

The distal end portion of the flat portion 35 has an overall mountain shape in which the front portion and the rear portion are cut obliquely when viewed from above. Here, the cut section in the distal end front portion of the flat portion 35 serves as a lead front guidance portion 37. Also, a notch portion 38 that is cut out so as to be concave toward the body 31 side when viewed from above is formed in the distal end crown portion of the flat portion 35.

The LED 30 is disposed so as to straddle the middle portion in the fore-aft direction of the lead frames 11 and 12 by having the extending direction of the flat portions 35 align with the lateral direction. At this time, the undersurface of the flat portion 35 of the lead terminals 33 and 34 is made to abut the top surface of the frame body 13 of the corresponding lead frame 11 or 12. Thereby, upon receiving the supply of electrical power from a power supply not illustrated, the LED 30 can light up. The position of the LED 30 at this time with respect to the lead frames 11 and 12 serves as the fixing position of the LED 30 in the explanation below.

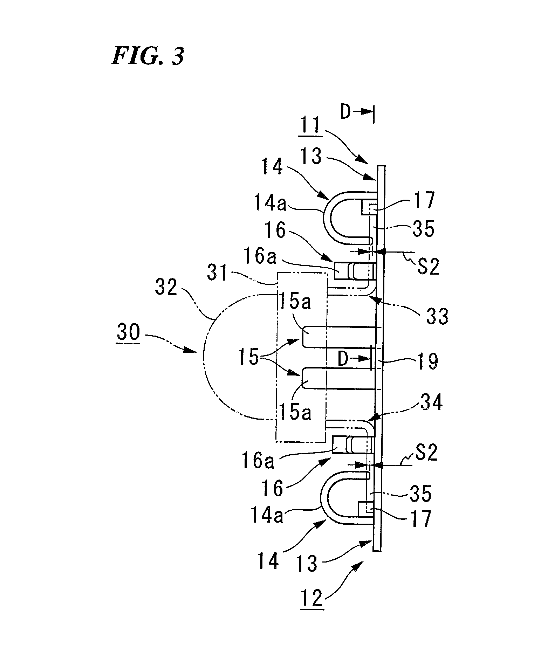

Explaining with reference to FIG. 3, a curl portion 14 is formed by the intermediate portion of each of the lead frames 11 and 12 in the fore-aft direction being cut up from the outside section in the lateral direction and, after extending upward, curving to the inside in the lateral direction and heading downward to be turned back. This curl portion 14 is formed in a desired shape by press molding a cut-out piece 14a that is integrally punch formed with the frame body 13, and by making the distal end edge thereof mainly follow along the top surface of the frame body 13, it is thereby disposed to face it.

The curl portion 14, together with the frame body 13, serves to clamp the flat portion 35, and a gap S2 that is smaller than the thickness of the flat portion 35 is formed between the distal end of the curl portion 14 and the top surface of the frame body 13. By inserting the flat portion 35 into this gap S2 while elastically deforming the curl portion 14 so as to widen the gap S2, the flat portion 35 can be resiliently clamped by the curl portion 14 and the frame body 13.

Here, the edge when the cut-out piece 14a is punched out remains at the distal end of the curl portion 14. This edge is forced against the top surface of the flat portion 35 by the resilience of the curl portion 14, and by biting thereinto, the curl portion 14 is enabled to firmly hold the flat plate portion 35. Also, an edge rear guiding portion 21 that is formed by being obliquely cut so as to rise upward toward the rear is formed at the distal end rear portion of the curl portion 14.

Each plate portion 35 is clamped by the curl portion 14 and the frame body 13 along the entire width when the LED 30 is in the aforesaid fixing position. The position of the plate-shaped terminals with respect to the lead frames at this time serves as the holding position of the plate portion 35 in the description below. The insertion of the plate portion 35 into the holding position is performed by shifting the plate portion 35 toward the front in the state of abutting the undersurface of the flat portion 35 onto the top surface of the frame body 13 from the rear of this holding position.

On the inside edge portions of the frame body 13 of the lead frames 11 and 12, overhang portions 22 that overhang in the gap S1 therebetween are formed. The rear-half portion of each overhang portion 22 is cut out so as to leave a belt-like piece 15a that extends rearward. The erect wall portion 15 that extends upward is formed by this belt-like piece 15a rising from the base portion thereof. This erect wall portion 15 is positioned directly ahead of the body 31 of the LED 30, which is in the fixing position, and the rear surface of the erect wall portion 15 abuts the front surface of the body 31 of the LED 30.

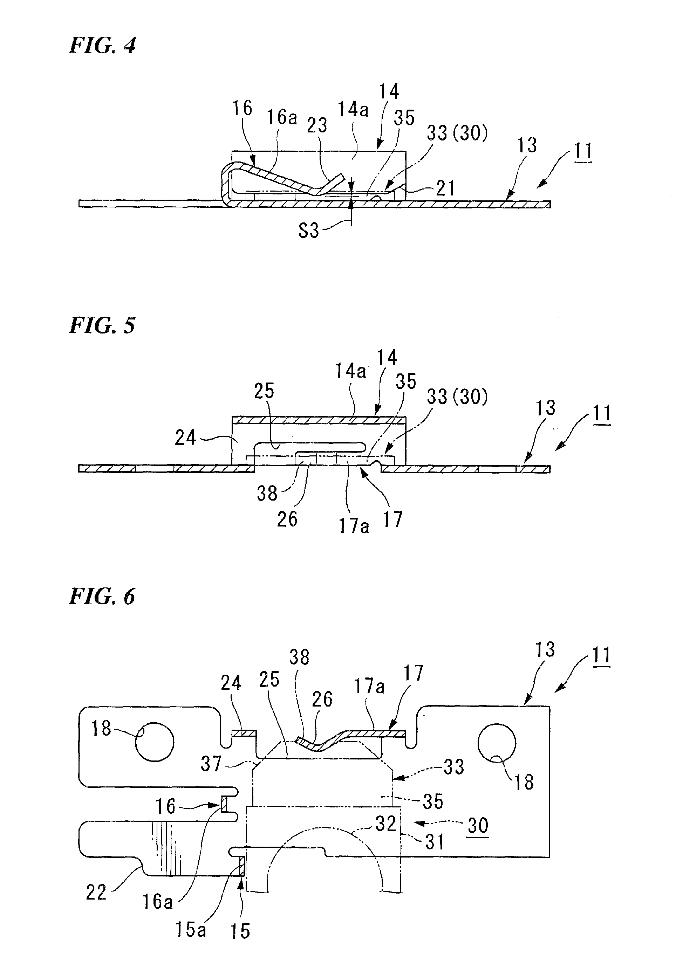

Describing with reference to FIG. 4, in the frame body 13 of each of the lead frames 11 and 12, the section further forward than the plate portion 35 in the holding position is cut out so as to leave a belt-like piece 16a that extends toward the front. This belt-like piece 16a rises from the base portion thereof and folds back to the rear. Thereby, an elastic piece 16 is formed that biases the flat portion 35, which is in the holding position, toward the frame body 13.

The elastic piece 16, after rising up directly ahead of the flat portion 35 in the holding position, folds back obliquely toward the lower rear, and a pressing portion 23 having an approximate V shape viewed from the side is formed at the distal end portion thereof. This pressing portion 23 is positioned in the vicinity of the middle in the fore-aft direction of the plate portion 35 in the holding position, and a gap S3 that is smaller than the thickness of the plate-shaped end portion 35 is formed between the bottom end of the pressing portion 23 and the top surface of the frame body 13. That is, by inserting the flat portion 35 into this gap S3 while elastically deforming the elastic piece 16 so as to widen the gap S3, the flat portion 35 can be pressed by the pressing portion 23 to come into close contact with the pressing portion 23 and the frame body 13.

Describing with reference to FIGS. 5 and 6, an opening portion 25 is formed in the standing portion of the curl portion 14 from the frame body 13 so as to extend across the outside wall 24 of the curl portion 14 and the frame body 13. This opening 25 is cut out so as to leave a belt-like piece 17a that extends from the rear portion of the outside wall 24 toward the front, and this belt-like piece 17a is formed as the elastic locking piece 17 that has a locking portion 26 in the front end portion thereof.

The locking portion 26 of the elastic locking piece 17 is formed so as to project in a mountain shape toward the inside in the lateral direction when viewed from above, and this locking portion 26 is capable of engaging with the notch portion 38 at the distal end of the flat portion 35 in the holding position. The distance between the locking portions 26 in the lead frames 11 and 12 is slightly less than the distance between the notch portions 38 of the lead terminals 33 and 34. Accordingly, the elastic locking piece 17 presses the locking portion 26 against the notch portion 38 to be elastically engaged while eliminating play therebetween.

Next, the procedure when fixing the LED 30 to a base part shall be described. First, the lead frames 11 and 12 are fixed to the base part with the screws 18a in the state of being connected by the joining piece 19. After connection to the base part, the lead frames 11 and 12 can be made independent by cutting the joining piece 19. At this time, since the lead frames 11 and 12 can be simultaneously fixed to the base part while accurately maintaining their relative positions, the work man-hours when fixing the lead frames 11 and 12 to a base part can be significantly reduced. The splitting of the lead frames 11 and 12 may also be performed after attaching the LED 30.

Next, the LED 30 is fixed to the base part via the lead frames 11 and 12. First, the LED 30 is placed on the frame body 13 at a position rearward of the fixing position with respect to the lead frames 11 and 12. Then, in the state of the undersurface of the plate portion 35 of each of the lead terminals 33 and 34 made to abut the top surface of the frame body 13 of the corresponding lead frame, that is, in the state of the plate-shaped terminals and consequently the LED 30 being positioned in the vertical direction, the LED 30 is shifted toward the front.

Thereby, the plate portion 35 is guided to the edge rear guiding portion 21 that is formed in the distal end rear portion of the curl portion 14 to be inserted into the gap S2 between the distal end of the curl portion 14 and the top surface of the frame body 13 while elastically deforming the curl portion 14 so as to widen the gap S2. When the flat portion 35 is inserted in the lead frames 11 and 12 until the holding position, since the front surface of the body 31 of the LED 30 abuts the rear surface of the erect wall portion 15, movement of the flat portion 35 of the LED 30 in the insertion direction (forward) is restricted. That is, the LED is positioned in the fore-aft direction.

Also, when inserting the flat portion 35, the flat portion 35 is guided toward the holding position while causing the lead front guidance portion 37, which is formed in the distal end front portion of the flat portion 35, to make contact with the outside wall 24 of the curl portion 14 and the elastic locking piece 17. By the engagement of the notch portion 38 at the distal end of the flat portion 35 and the locking portion 26 of the elastic locking piece 17, movement and rotation of the flat portion 35 and consequently the LED 30 in directions along the top surface of the frame body 13 (that is, the fore-aft and lateral directions) are restricted. Thereby, the LED 30 is fixed to the base part in a state of being positioned at the aforesaid fixing position.

In the state of the LED 30 having been fixed to the base part, the flat portion 35 is pressed against the frame body 13 by the elastic force of the elastic piece 16 in addition to the elastic force of the curl portion 14. For this reason, the passage of current between the flat portions 35 and the lead frames 11 and 12 is reliable, and the heat dissipation from the lead terminals 33 and 34 to the lead frames increases.

Also, in the state of each of the flat portions 35 held in a resilient manner by the curl portion 14 and the frame body 13, the flat portion 35 is firmly held by the edge of the distal end of the curl portion 14 biting into the flat portion 35. From this, movement of the flat portion 35 and consequently the LED 30 in directions along the top surface of the frame body 13 is reliably restricted. Simultaneously, due to the notch engagement of each flat portion 35 and the elastic locking piece 17, movement of the flat portion 35 and consequently the LED 30 in directions along the top surface of the frame body 13 is more reliably restricted.

Here, fixing of the LED 30 to the base part is performed so as to attach the LED 30 to the lead frames 11 and 12 using a predetermined tool, and in the reverse procedure, the LED 30 can be removed from the base part. That is, compared to the case of the lead terminals 33 and 34 of the LED 30 being fixed to the lead frames 11 and 12 by soldering or the like, the LED 30 is easily detachable with respect to the base part.

As described above, the lead frames 11 and 12 in the aforementioned embodiment detachably fix the LED 30 having the plate-shaped lead terminals 33 and 34 to the base part. By erecting and folding back the cut-out piece 14a that is integrally formed on the frame body 13, the distal end thereof becomes the curl portion 14 that is formed so as to face the top surface of the frame body 13. Furthermore, the lead terminals 33 and 34 that are inserted between the top surface of the frame body 13 and the distal end of the curl portion 14 are clamped by the frame body 13 and the curl portion 14.

According to this constitution, the fixing of the LED 30 to the base part can be performed by insertion of the lead terminals 33 and 34 between the top surface of the frame body 13 of the lead frames 11 and 12, which are fixed in advance to the base part, and the distal end of the curl portions 14. In the reverse procedure, the LED 30 can be removed from the base part. In this way, since the LED 30 is comparatively easily detachable from a base part, there is the effect that the work man-hours when fixing and replacing the LED 30 to a base part can be reduced.

At this time, the edge of the distal end of the curl portion 14 is made to bite into the lead terminals 33 and 34. Thereby, not only movement of the lead terminals 33 and 34 in a direction vertical to the surface of the frame body 13 but also movement in a direction along the surface of the frame body 13 can be effectively restricted. For this reason, there is the effect that dropping out of the LED 30 and poor contact with the lead frames 11 and 12 can be prevented.

Moreover, since the curl portion 14 that clamps the lead terminals 33 and 34 is integrally provided with the frame body 13, it is possible to suppress an increase in the number of parts of the lead frames 11 and 12. For this reason, there are the effects that the cost of components can be reduced, and the work man-hours required for fixing the LEDs 30 and the work man-hours for parts management can be reduced.

Also, in the lead frames 11 and 12, in order to cause the lead terminals 33 and 34 to make surface contact with the top surface of the frame body 13, an elastic piece 16 is provided in the frame body 13 to bias the lead terminals 33 and 34 to the frame body 13 side. By doing so, during fixation of the LED 30 it is possible to cause the lead terminals 33 and 34 to make surface contact with the frame body 13. By doing so, it is possible to improve the dissipation from the lead terminals 33 and 34 of the heat produced from the LED 30, and improve the reliability of contact between the lead frames 11 and 12 and the lead terminals 33 and 34.

Moreover, in the lead frames 11 and 12 described above, the elastic locking piece 17 that engages with the notch portion 38 that is provided in the lead terminals 33 and 34 is provided in the frame body 13. By doing so, the elastic locking piece 17 engages with the notch portion 38 during fixation of the LED 30, whereby it is possible to perform positioning of the lead terminals 33 and 34 with respect to the frame body 13 in each direction. Thereby, there is the effect of facilitating the work of fixing the LED 30 to the base part. Also, since it is possible to restrict movement of the lead terminals 33 and 34 in directions with respect to the frame body 13, there is the effect that dropping out of the LED 30 and poor contact with the lead frames 11 and 12 can be more effectively prevented.

Moreover, it can be said that adopting the fixing structure for fixing the LED 30 using the lead frames 11 and 12 for a vehicle lamp in which numerous LEDs 30 are exposed to various vibrations is particularly effective.

While the preferred embodiment of the invention has been described and illustrated above, it should be understood that the constitutions in the aforedescribed embodiment are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

For example, in the aforementioned embodiment, the cut-out piece 14a that forms the curl portion 14 may be a separate metal plate that is joined by welding or the like to the frame body 13, instead of being integrally formed with the frame body 13. Also, the distal end of the curl portion 14 (the distal end of the cut-out piece 14a) may be formed to have, for example, a wave shape instead of being formed so as to follow the top surface of the frame body 13.

### INDUSTRIAL APPLICABILITY

The present invention may be favorably used in the case of adopting, for example, a light emitting diode as a light source in a lamp for a vehicle or the like.

## Claims

1. A fixing device for a light emitting diode having plate-shaped lead terminals, comprising:
a device body that is to be fixed to a base part; and
a cut-out piece formed integrally with the device body and fixing the lead terminals to a surface of the device body, wherein
the cut-out piece is formed so that a distal end of the cut-out piece faces the surface of the device body by being erected and folded back from the device body, and
the light emitting diode is detachably fixed to the base part by clamping each of the lead terminals inserted between the distal end of the cut-out piece and the surface of the device body.

2. The fixing device for a light emitting diode according to claim 1, wherein
the device body includes an elastic piece that urges the lead terminals toward the device body in order to cause the lead terminals to make surface contact with the surface of the device body.

3. The fixing device for a light emitting diode according to claim 1, wherein
the device body includes a locking piece that engages a notch portion provided on each of the lead terminals in order to perform positioning of the lead terminals with respect to the device body.

4. A fixing structure for a light emitting diode by using the fixing device according to any one of claims 1 through 3 to fix a light emitting diode.
